# EUROPÄISCHE PATENTSCHRIFT

(11) **EP 2 304 075 B1**
(45) Veröffentlichungstag und Bekanntmachung des Hinweises auf die Patenterteilung: **25.03.2015**
(21) Anmeldenummer: 09780878.6
(22) Anmeldetag: 21.07.2009
(51) Int. Cl.: C23C 16/458, C23C 16/448, C23C 16/455, C23C 16/34, C23C 16/36

(54) **CVD-REAKTOR ZUR ABSCHEIDUNG VON SCHICHTEN AUS EINEM REAKTIONSGASGEMISCH AUF WERKSTÜCKEN**
CHEMICAL VAPOR DEPOSITION REACTOR FOR DEPOSITING LAYERS MADE OF A REACTION GAS MIXTURE ONTO WORKPIECES
RÉACTEUR DE DÉPÔT CHIMIQUE EN PHASE VAPEUR POUR LE DÉPÔT DE COUCHES COMPOSÉES D'UN MÉLANGE DE RÉACTION SUR DES PIÈCES

(30) Priorität: 23.07.2008 DE 102008034330
(43) Veröffentlichungstag der Anmeldung: 06.04.2011
(73) Patentinhaber: IHI Ionbond AG, 4600 Olten (CH)
(72) Erfinder: AUGER, Michael, 8887 Mels/SG (CH); BONETTI, Renato, CH-4652 Winznau (CH); STRAKOV, Hristo, 4600 Olten/SO (CH)
(74) Vertreter: Hoffmann Eitle
(86) Internationale Anmeldenummer: PCT/EP2009/059360
(87) Internationale Veröffentlichungsnummer: WO 2010/010088

(56) Entgegenhaltungen:
- EP-A2- 0 270 991
- EP-A2- 0 572 150
- GB-A- 2 379 450
- US-A- 4 745 088
- US-A- 5 324 540
- US-A- 5 441 570
- US-A1- 2007 010 072

## Beschreibung

### TECHNISCHES GEBIET

Die vorliegende Erfindung betrifft einen CVD-(Chemical Vapor Deposition)-Reaktor zur Verwendung bei der Gasphasenabscheidung von Überzügen, insbesondere Hartstoffüberzügen, auf Werkstücken bzw. deren Oberflächen.

Allgemein werden die Begriffe "Gasphasenabscheidung" und "CVD" (vom englischen Begriff "Chemical Vapor Deposition") synonym verwendet. Es handelt sich um ein Verfahren zur Erzeugung von Schichten, insbesondere dünner Schichten, auf den Oberflächen anderer Materialien (Substrate), wie beispielsweise Werkstücken für die Metallverarbeitung (z. B. Schneidplättchen, Sägeblätter etc.). Die Gasphasenabscheidung ist dadurch gekennzeichnet, dass chemische Reaktionen der im Reaktionsgas enthaltenen chemischen Verbindungen ablaufen, und sich die gewünschten Hauptprodukte der chemischen Reaktionen auf der Oberfläche des Substrats abscheiden und dort eine Beschichtung bzw. einen Überzug bilden. Allfällige Reaktionsnebenprodukte fallen gasförmig an und müssen zur Gewährleistung der Schichteigenschaften aus dem Gasgemisch entfernt werden. Dies geschieht über eine Abgasleitung welche entweder die Gase über einen Gaswäscher in die Atmosphäre führt, oder diese aber via Vakuumpumpe der Neutralisation zuleitet. Das Arbeiten bei Vakuum ermöglicht eine gute Prozesskontrolle auch bei schnellen Reaktionen und gleicht dank niedrigen Verweilzeiten die durch die Konzentrationsabnahme (depletion) bedingte Schichtdickenverringerung in Flussrichtung aus.

Die vorliegende Erfindung betrifft insbesondere einen Rohrreaktor und hierbei insbesondere einen Heißwandreaktor. Mit anderen Worten betrifft die vorliegende Erfindung einen CVD-Reaktor, bei dem die chemischen (beispielsweise thermischen) Reaktionen bei einer Temperatur (des Reaktionsgases) von mehr als 720°C stattfinden können. Die Abscheidungstemperaturen liegen vorzugsweise zwischen 800 und 1200 °C. Der CVD-Reaktor der vorliegenden Erfindung unterscheidet sich daher von Reaktoren für die Halbleiterbeschichtung, bei denen die Temperaturen meist unterhalb 500°C liegen.

### HINTERGRUND DER ERFINDUNG

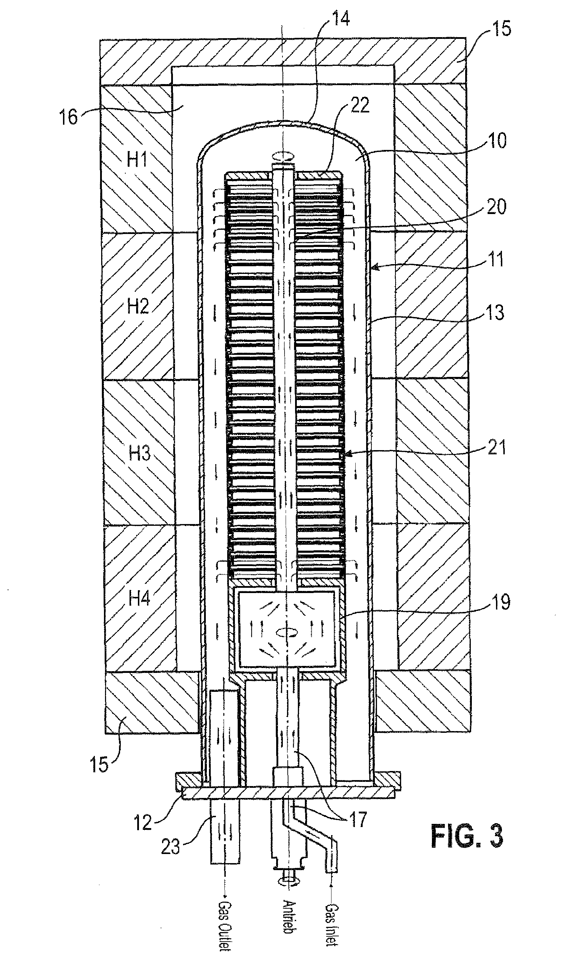

CVD-Reaktoren der eingangs genannten Art sind im Stand der Technik gut bekannt. Dabei geht die Erfindung von einem CVD-Reaktor aus, wie er in Fig. 3 dargestellt ist. Der dargestellte CVD-Reaktor umfasst eine zylinderförmige vertikale Reaktorkammer 10, die durch eine Reaktorwandung 11 sowie einen Reaktorboden 12 begrenzt ist. Die Reaktorwandung 11 ist kuppelförmig ausgestaltet und umfasst einen hohlzylindrischen Abschnitt und eine dem Reaktorboden abgewandte Kuppel 14. Entlang der Reaktorwandung 11 sind mehrere Heizungen 1-4 vorgesehen mittels derer die Reaktorwandung 11 beheizbar ist. Im oberen und unteren Bereich finden sich entsprechende Abschlüsse 15. Der Reaktor ist damit im Wesentlichen in einem homogen beheizten Raum 16 angeordnet.

Der dargestellte CVD-Reaktor umfasst ferner eine zentrale Einlassleitung 17 zum kontinuierlichen Einströmen von Reaktionsgas. Die zentrale Einlassleitung ist durch ein Zentralrohr gebildet, das über einen Antrieb 18 drehbar ist. Stromab des Durchtritts der Einlassleitung 17 durch den Reaktorboden 12 ist eine Vorwärmkammer 19 in dem Einlassrohr integriert, die durch einen Behälter mit darin vorgesehenen Strömungsumleitungen bzw. Schikanen (nicht dargestellt) gebildet ist. Stromab der Vorwärmkammer 19 sind in dem zentralen Einlassrohr mehrere Gasauslässe 20 vorgesehen.

Ferner ist in der Reaktorkammer 10 eine zentral angeordnete, etagenförmige Werkstückaufnahme 21 angeordnet. Diese umfasst mehrere tablettförmige Aufnahmen, die übereinander angeordnet sind. Zwischen jeweils zwei Aufnahmen sind die Etagen gebildet. Die Gasauslässe 20 des zentralen Einlassrohrs 17 sind jeweils auf Höhe einer Etage angeordnet und münden oberhalb der Werkstücktablette in die jeweilige Etage. An ihrem radial äußeren Ende stehen die jeweiligen Etagen mit der Reaktorkammer 10 in Fluidverbindung. Oberhalb der obersten Etage ist ferner eine Abschlussplatte 22 vorgesehen.

Das über den Antrieb 18 rotierbare zentrale Einlassrohr 17 ist in der etagenförmigen Werkstückaufnahme 21 drehbar gelagert.

Ferner durchtritt eine Auslassleitung 23 den Reaktorboden 12 und bildet einen Auslass für verbrauchtes Reaktionsgas aus der Reaktorkammer 10.

Bei dieser Lösung bestehen mehrere Problematiken. Zum einen bestehen bei der Vorwärmkammer 19 hinsichtlich ihrer Oberfläche, die mit dem einströmenden Reaktionsgas in Kontakt kommt, Grenzen, d. h. die Oberfläche kann nur schwer und verbunden mit der Integration weiterer strömungshindernder Schikanen vergrößert werden, wenn die Vorwärmkammer an sich nicht vergrößert werden soll. Es bestehen Bestrebungen die einströmende Gasmenge (Reaktionsgas) zu erhöhen und dadurch den Beschichtungsprozess zu verkürzen und/oder die Schichtdicke über das Reaktorvolumen in engen Grenzen zu halten. Bei höheren Gasmengen muss jedoch auch die Heizkapazität der Vorwärmkammer erhöht werden.
An den inneren Oberflächen wird zudem ein Teil des reaktiven Gasgemisches vorzeitig konsumiert.

Darüber hinaus wird durch die Strömungsumleitungen in der Vorwärmkammer die Geschwindigkeit des Reaktionsgases reduziert. Dadurch besteht verstärkt die Problematik, dass bereits in der Vorwärmkammer ein gewisser Abscheidungsprozess auf den Oberflächen der Vorwärmkammer stattfindet. Dies ist insbesondere bei Reaktionsgasen ein Problem, die Lewis-Säuren und Lewis-Basen enthalten. Dort begegnet man häufig Abscheidungsproblemen. Ein Beispiel ist das System TiCl4/CH3C. Die in dem rotierbaren zentralen Einlassrohr 17 angeordnete und selbst mitrotierende Vorwärmkammer ist aufwändig zu demontieren und zu zerlegen, da die vorzeitige Beschichtung die Teile der Kammer zusammenschweißt, so dass die Reinigung der Vorwärmkammer, d. h. das Entfernen der Ablagerungen in der Vorwärmkammer, problematisch und zeitaufwändig ist. Bei sehr reaktiven Gasgemischen kann es lokal zu starkem Schichtaufbau führen, was im Extremfall zu Verstopfungen führt.

Schließlich gestaltet es sich mit der Vorwärmkammer auch schwierig die Temperatur der vorzuwärmenden Gase exakt zu regeln und zu steuern. Ein zusätzlicher großer Nachteil besteht darin, dass alle reaktiven Gase vor der rotierenden Vorwärmkammer gemischt werden müssen.

Wie es Fig. 3 zu entnehmen ist, wird über einen feststehenden, mit dem Reaktorboden 12 in Verbindung stehenden Gaseinlass das Reaktionsgas in das zentrale Einlassrohr 17 eingespeist. Das zentrale Einlassrohr 17 wird über den Antrieb 18 rotiert. Dadurch entsteht eine Schnittstelle zwischen dem feststehenden Gaseinlass und dem zentralen Einlassrohr 17. Diese Schnittstelle ist im Bereich des Reaktorbodens 12 ausgestaltet und bereitet insbesondere bei der Dichtung erhebliche Probleme, das ein Austreten von Reaktionsgas an der besagten Schnittstelle und damit aus dem Reaktor insbesondere aufgrund der Halterung der Dichtung unter den gegebenen hohen Temperaturen nicht vollständig vermeidbar ist. Dies ist insbesondere bei hochreaktiven, insbesondere korrosiven Ausgangsstoffen ein gravierendes Problem.

Beim Einsatz von Ausgangsprodukten mit tiefen Dampfdrücken muss diese Stelle auf Temperaturen über 200°C beheizt werden was eine teure und aufwändige Dichtungstechnik der rotierenden Durchführung bedingt.

Bekannte CVD-Reaktoren bieten zu den oben genannten Problemen keine Lösungen. Die DD 111 935 offenbart beispielsweise die fallende Einleitung eines Reaktionsgases über ein zentrales mit Gasauslässen versehenes Einlassrohr, das im Bereich des Reaktordeckels in die Reaktorkammer tritt. Ferner wird hier vorgeschlagen die zentrale Einlassleitung zu kühlen. Letzteres steht in eklatantem Widerspruch zu der Vorgabe das Reaktionsgas vor der Einleitung in die Reaktorkammer vorzuwärmen. Ferner lehrt DD 111 935 explizit eine Strömung aus dem zentralen Einlassrohr nach außen zu der Reaktorwandung, um eine erhöhte Abscheidungsrate an der Reaktorwandung zu vermeiden.

Die DE 197 43 922 schlägt ein stetiges Umschalten der Reaktionsgasströmung in die Reaktorkammer vor. Dabei strömt das Reaktionsgas außerhalb eines Zentralrohrs über die zu beschichtenden Werkstücke und über eine dem Reaktorboden abgewandte Öffnung des Zentralrohrs in das Zentralrohr und aus dem Reaktor oder - nach dem Umschalten - in umgekehrter Richtung durch das zentrale Rohr aufsteigend aus der dem Reaktorboden abgewandten Öffnung und von dort nach unten über die zu beschichtenden Werkstücke aus der Reaktorkammer heraus. Hierfür ist eine relativ aufwändige Zweiwegeventilanordnung, die hohen Temperaturen standhalten muss, vorgesehen und darüber hinaus die Integration einer Gasvorwärmung und Durchmischung besonders wenn Reaktanden mit niedrigen Dampfdrücken vorliegen vor dem Beschichten der Werkstücke schwierig zu gestalten, da die Vorwärmung je nach unterschiedlicher Ventilstellung an unterschiedlichen Auslässen vorzunehmen wäre.

Die EP 0 164 928 A2 betrifft einen vertikal stehenden Heißwand-CVD-Reaktor mit zwei parallel in den Randbereichen verlaufenden Einlass- bzw. Auslassleitungen, die durch den Boden des Reaktors in die Reaktorkammer treten und sich von dort bis zur obersten Etage einer etagenförmigen Werkstückaufnahme erstrecken. Die Werkstückaufnahme ist drehbar gelagert. Dabei sollen die Substrate, die zu beschichten sind, in der Mitte der Rotationsachse der Werkstückaufnahme platziert werden und damit exakt mittig zwischen Ein- und Auslassleitung.

Die US 2006/0159847 A1 weist zwei Einlassrohre auf, die sich vermutlich durch den Boden und von dort bis zur obersten Etage einer Werkstückaufnahme erstrecken. Die Werkstückaufnahme selbst ist nicht drehbar. Vielmehr sind die Einlassleitungen um 360° drehbar, wobei auch hier die Werkstückaufnahme mittig zwischen Einlass und Auslass angeordnet sein soll.

Die US 2007/0246355 A1 offenbart ebenfalls eine Einlassleitung, die sich vom Boden bis zur oberen Etage erstreckt und eine Auslassleitung im Bereich des Bodens. Ferner ist eine drehbare Werkstückaufnahme vorgesehen.

Bezüglich der EP 0 270 991 B1 ist eine feststehende Einlassleitung zentral, d. h. mittig zur Reaktorkammer angeordnet ist von einer drehbaren Auslassleitung umgeben.

Darüber hinaus sind zwei Werkstückaufnahmen links und rechts von der Ein- und Auslassleitung angeordnet und in einer inneren Reaktorkammer aufgenommen, welche wiederum von einer äußeren Reaktorkammer umgeben ist. Die zentrale Auslassleitung ist drehbar. Wird diese Auslassleitung gedreht, so dreht sich mit ihr die Grundplatte, welche die Werkstückaufnahmen mitnimmt, so dass sich diese um die Auslassleitung drehen. Durch diese Drehung und das Abstützen der Zahnräder an dem feststehenden Zahnrad drehen sich die Werkstückaufnahmen selbst um ihre Mittelachsen.

Die DE 78 28 466 U1 betrifft die Beschichtung von Werkstücken, insbesondere Werkzeugen. Hier wird eine zentrale Einlassleitung rotiert, nicht aber die feststehende Werkstückaufnahme.

### ZUSAMMENFASSUNG DER ERFINDUNG

Angesichts der obigen Ausführungen besteht daher die Aufgabe der vorliegenden Erfindung den in Bezug auf Fig. 3 eingangs beschriebenen CVD-Reaktor derart weiterzubilden, dass größere Gasmengen bei gleich bleibenden Schichteigenschaften und gleich bleibender Homogenität (Schichtdicke) einströmbar ist, so dass eine gleichwertige aber schnellere Beschichtung der Werkstücke im Vergleich zum Stand der Technik geschaffen wird und die Dichtungsproblematik vermindert ist.

Diese Aufgabe wird durch einen CVD-Reaktor mit den Merkmalen des Patentanspruchs 1 gelöst. Vorteilhafte Weiterbildungen der vorliegenden Erfindung sind in den Unteransprüchen genannt.

Der vorliegenden Erfindung liegt der Gedanke zu Grunde das Reaktionsgas vorzugsweise im Wesentlichen parallel, in jedem Fall aber nahe der beheizten Reaktorwandung in die Reaktorkammer einzuströmen, so dass die großflächige Oberfläche der Reaktorwandung zum Vorheizen des Reaktionsgases genutzt werden kann. Um die Homogenität und die sonstigen Schichteigenschaften im Vergleich zum Stand der Technik aufrechtzuerhalten, wird darüber hinaus und erfindungsgemäß die etagenförmige Werkstückaufnahme rotiert.

Der CVD-Reaktor der vorliegenden Erfindung umfasst eine längliche vertikal verlaufende Reaktorkammer, die durch eine zumindest teilweise beheizbare Reaktorwandung und einen Reaktorboden begrenzt ist. Vorzugsweise ist die Reaktorkammer zylinderförmig mit bevorzugterweise kreisrundem Querschnitt (achteckige, polyedrische oder andere Querschnitte sind ebenfalls denkbar). Die Reaktorwandung kann sich dabei beispielsweise aus einem hohlzylindrischen Teil und einer ein Ende des Hohlzylinders verschließenden Kuppel zusammensetzen. Am anderen Ende des Hohlzylinders ist der Reaktorboden vorgesehen. Des Weiteren umfasst der erfindungsgemäße CVD-Reaktor eine oder mehrere Einlassleitungen zum Einströmen, insbesondere kontinuierlichen Einströmen, des Reaktionsgases in die Reaktorkammer. Dabei tritt die Einlassleitung im Bereich des Reaktorbodens, vorzugsweise durch den Reaktorboden, in die Reaktorkammer. Ferner ist eine, vorzugsweise zentrale Auslassleitung zum, vorzugsweise kontinuierlichen, Ausströmen des verbrauchten Reaktionsgases (das also sowohl die nicht-umgesetzten Edukte als auch die Reaktionsprodukte einschließt) aus der Reaktionskammer vorgesehen, die ebenfalls im Bereich des Reaktorbodens, vorzugsweise durch den Reaktorboden, aus der Reaktorkammer tritt. Darüber hinaus ist eine etagenförmige Werkstückaufnahme, die, vorzugsweise zentral, in der Reaktorkammer angeordnet ist, um ihre Mittelachse, hier vorzugsweise die Mittelachse der bevorzugt zentralen Auslassleitung, und ggf. der Reaktorkammer. Etagenförmig bedeutet hier, dass ein oder mehrere Tabletts oder Tische vorgesehen sein können, die ggf. vertikal übereinander jeweils eine Etage bilden und die zu beschichtenden Werkstücke liegend aufnehmen. Es sind darunter aber auch Gestelle zu verstehen, die die Werkstücke hängend aufnehmen.

Aus dieser Anordnung ergibt sich, dass die Einlassleitung zwischen der zentralen Auslassleitung bzw. der etagenförmigen Werkstückaufnahme und der Reaktorwandung angeordnet ist, die beheizbar ist, so dass das Gas direkt oder indirekt entlang der Reaktorwandung strömt und durch die von der Reaktorwandung abgestrahlte Wärme ausreichend vorgewärmt wird. Durch diese Anordnung und im Vergleich zur Vorwärmkammer größere Oberfläche der Reaktorwand und kann eine schnellere Aufheizung im Gegensatz zur Verwendung der Vorwärmkammer erzielt werden, so dass größere Gasmengen einströmbar sind und ohne die Strömungsgeschwindigkeit durch Schikanen bzw. Umleitungen zu reduzieren. Wie erwähnt, bringen Schikanen bzw. Umleitungen insbesondere dann, wenn Lewis-Säuren und Lewis-Basen als Ausgangsstoffe vorliegen, erhebliche Abscheidungsprobleme mit sich. Insgesamt ergibt sich der Vorteil, dass eine schnellere Beschichtung stattfinden kann, wobei unter anderem durch die Drehung der etagenförmigen Werkstückaufnahme die Homogenität und die weiteren Schichteigenschaften im Vergleich zum Stand der Technik wenigstens gleichbleibend sind. Darüber hinaus handelt es sich bei der Innenfläche der Reaktorwandung um eine im Wesentlichen glatte Oberfläche, die im Vergleich zur Vorwärmkammer gut zugänglich und damit gut reinigbar ist und auch kein zeitintensives und aufwändiges Zerlegen erfordert. Durch Anbringen von leicht austauschbaren "Prallplatten" können zudem die zeitliche Verfügbarkeit von CVD-Anlagen verbessert werden, da keine langen Zeiten zum Reinigen zwischen zwei Chargen benötigt werden. D. h. bei der Reinigung werden einfach die "Prallplatten" getauscht. Des Weiteren ist insbesondere, wenn mehrere Heizelemente vorgesehen sind, die getrennt voneinander regelbar sind, eine gute Temperaturkontrolle des Reaktionsgases über die gesamte Höhe des CVD-Reaktors möglich, was zu einer gleichmäßigeren und homogeneren Schichtverteilung über die in den verschiedenen Etagen angeordneten Werkstücken führt. Die Dichtung einer Schnittstelle mit sich drehenden Elementen ist, wie es eingangs beschrieben wurde, schwierig und damit aufwändig. Bei der vorliegenden Erfindung wird die etagenförmige Werkstückaufnahme gedreht, wohingegen die zentrale Auslassleitung feststeht. Auch die Einlassleitung ist feststehend. Damit besteht im Wesentlichen keine Schnittstelle gasführender Elemente im Bereich des Reaktorbodens, von denen sich wenigstens ein Element dreht.

Insbesondere um die Abscheidung an der Reaktorwandung zu vermindern, ist es von besonderem Vorteil, und ggf. unabhängig von der Rotation der etagenförmigen Werkstückaufnahme, die Einlassleitung als Rohr auszugestalten, das sich parallel zum beheizbaren Teil der Reaktorwandung erstreckt, z. B. parallel zu einem Abschnitt des hohlzylinderischen Teils oder dem gesamten hohlzylindrischen Teil der Reaktorwandung. Dabei kann das Rohr aus Wärme übertragendem Material bestehen, um das Gas bzw. die Gase bereits in der Einlassleitung vorzuwärmen oder aber aus Wärme isolierendem Material (siehe später).

Ferner ist es von Vorteil, wenn sich das Einlassrohr vom Reaktorboden im Wesentlichen bis zur obersten Etage der Werkstückaufnahme und ggf. auch darüber hinaus oder zumindest bis nahe zur obersten Etage erstreckt. Dies ermöglicht es auf besonders einfache Art und Weise den Weg des Reaktionsgases nach dem Austritt aus dem Einlassrohr zu den zu beschichteten Werkstücken auf ein kleinstmögliches Maß zu reduzieren und gleichzeitig den Abstand zur Reaktorwandung klein zu halten, um die Vorheizung optimal zu gestalten.

Basierend auf dieser Ausgestaltung bieten sich mehrere Ausführungsmöglichkeiten, die auch kombinierbar sind.

So ist es vorteilhaft, wenn pro Etage der Werkstückaufnahme entsprechend der der jeweiligen Etage wenigstens eine Öffnung in dem Einlassrohr vorgesehen ist und die Etagen radial zugänglich sind (es besteht eine Fluidverbindung zwischen Reaktorkammer und den Etagen), so dass Reaktionsgas aus den Öffnungen des Einlassrohrs radial entlang der Etagen, d. h. über und an den zu beschichtenden Werkstücken vorbei, zur zentralen Auslassströmung strömbar ist.

Dabei können die Öffnungen zur Reaktorwandung gerichtet sein, so dass das Reaktionsgas gegen die Reaktorwandung strömt (strömbar ist) und eine zusätzliche Vorheizung erfährt, wonach es auf kürzestem Weg entlang der Substrate (Werkstücke) zur Auslassleitung strömbar ist. Unerwünschte Ablagerungen aus Nebenreaktionen mit Verunreinigungen im Reaktionsgasgemisch werden an der heißen Reaktorwand resp. an den "Prallplatten" abgelagert. Dadurch können Beschichtungen mit hohen Oberflächengüten erzeugt werden.

Um eine möglichst laminare Strömung und damit gleichmäßige Begasung der Werkstücke erzielen zu können, ist es ferner bevorzugt, dass die Auslassleitung ein Rohr ist, das sich zentral vom Reaktorboden zur obersten Etage erstreckt und pro Etage auf Höhe der jeweiligen Etage wenigstens eine Öffnung zum Einströmen des verbrauchten Reaktionsgases in das Auslassrohr aufweist. D. h. das Auslassrohr weist pro Etage wenigstens eine Öffnung auf, um die Fluidverbindung zwischen den Etagen und dem Auslassrohr zu schaffen.

Alternativ oder zusätzlich zu der obigen Ausführungsform kann das Einlassrohr an seinem dem Reaktorboden abgewandtem Ende offen sein, d. h. im Bereich der obersten Etage. In einer Abschlussplatte, die die Werkstückaufnahme an ihrem dem Reaktorboden abgewandten Ende verschließt, sind dabei vorzugsweise Öffnungen vorgesehen, so dass das Reaktionsgas aus der Öffnung des Einlassrohrs durch die Öffnung in die Abschlussplatte in Richtung des Reaktorbodens und über die zentrale Auslassleitung aus der Reaktorkammer strömbar ist. Hierfür kann das Auslassrohr, wie oben beschrieben, vom Reaktorboden zur obersten Etage mit in dem Auslassrohr vorgesehenen Öffnungen ausgestaltet sein oder aber kürzer und im Bereich der untersten Etage trichterförmig an die unterste Etage anschließen, um sich von dort zum Reaktorboden zu erstrecken.

Das Auslassrohr kann mit gleich großen, gleich beabstandeten oder mit spezifisch der Beschichtungsaufgabe zur Optimierung der Strömungen angepassten Bohrungen bzw. Öffnungen versehen werden.

Bei letzterer Ausgestaltung alleine ist es ferner von Vorteil, wenn das Reaktionsgas nur im Bereich der Kuppel mit der Rekatorwandung in Kontakt kommt. Dabei könnte die Reaktorkuppel beispielsweise vom hohlzylindrischen Abschnitt Reaktorwandung abkoppelbar sein, um diesen Teil separat reinigen zu können. Bei dieser Ausführung wird die Werkstückaufnahme ebenfalls rotiert.

Bei der Verwendung einer Vorwärmkammer, wie sie unter Bezugnahme auf Fig. 3 beschrieben wurde, besteht ein zusätzliches Problem, wie folgt. Bei manchen CVD-Prozessen bilden sich die reaktiven Spezies in der Gasphase erst bei höheren Temperaturen. In dem in Fig. 3 gezeigten Reaktor geschieht dies in der Vorwärmkammer, verbunden mit den bereits beschriebenen Problemen mit Abscheidungen, insbesondere auf den Schikanen und Umleitungen. Erfindungsgemäß ist es daher von Vorteil, mehrere (insbesondere zwei oder drei) der besagten Einlassleitungen vorzusehen, über die mehrere unterschiedliche Reaktionsgase getrennt in die Reaktorkammer strömbar sind, um sich in der Reaktorkammer zu dem eigentlichen Reaktionsgas zu mischen. D. h. die Mischung der mehreren Reaktionsgase zu dem Reaktionsgas erfolgt erst in der Reaktorkammer, d. h. nach dem Verlassen der Einlassleitungen, wobei, wie es oben erwähnt wurde, der Weg zwischen der bzw. den Einlassleitungen zu den Werkstücken klein ist, so dass auch der Bereich klein ist, in dem sich Ablagerungen bilden können. Die Gase, die durch die mehreren Einlassleitungen strömen, um sich zum eigentlichen Reaktionsgas zu mischen, werden im Rahmen der vorliegenden Beschreibung der Einfachheit halber ebenso als "Reaktionsgase" bezeichnet, auch wenn sie präziser als "Ausgangsgase" zu bezeichnen wären, die sich in der Reaktorkammer zu dem eigentlichen Reaktionsgas mischen. Die Ausgangsgase können dabei ihrerseits wieder aus einer Gasmischung bestehen, die beispielsweise auch Inertgase, wie Stickstoff oder Argon, enthält. Vorzugsweise handelt es sich jedoch um Einzelgase geeigneter Reinheit.

Bevorzugterweise kann die Einlassleitung mehrere Kanäle aus Wärme isolierendem Material (z. B. Keramik) umfassen. Dies erlaubt die Zuführung der Gase und Dämpfe in relativ kaltem Zustand, gefolgt von einem raschen Vermischen im heißen Bereich in unmittelbarer Nähe des zu beschichtenden Materials. Auf dieser Art und Weise wird ein sehr gut kontrollierter Prozess gewährleistet, in dem unerwünschte Nebenreaktionen vermieden werden.

Insbesondere bei der Ausgestaltung, bei der die Einlassleitung an ihrem dem Reaktorboden angewandten Ende offen ist, ist es daher von Vorteil einen Mischraum in der Reaktorkammer zu definieren, der zwischen der Abschlussplatte und der Kuppel definiert ist, so dass die Mischung der mehreren Reaktionsgase (Ausgangsgase) zur Bildung des Reaktionsgases in diesen Mischraum stattfinden kann.

Bei der Ausgestaltung mit den mehreren Öffnungen entlang der Länge des Einlassrohrs auf Höhe der jeweiligen Etagen ist es von Vorteil, wenn die Einlassleitungen entsprechende Öffnungen auf gleicher Höhe aufweisen und die Öffnungen so ausgerichtet sind, z. B. einander zugewandt sind oder auf denselben Bereich der Reaktorwandung, resp. Prallplatten, gerichtet sind, dass die ausströmenden Reaktionsgase aufeinander treffen und eine gute Durchmischung der Gase und schnelle Verbindung (Reaktionsgas) erfolgt, ohne dass der Weg zu den Werkstücken mit der damit verbundenen Problematik von Abscheidungen auf nicht gewünschten Oberflächen vergrößert wird.

Um die Drehung der Werkstückaufnahme auf einfachste mechanische Art und Weise erzielen zu können, ist es von Vorteil, dass die Werkstückaufnahme im Bereich des Reaktorbodens eine Innenverzahnung aufweist, in die ein angetriebenes Zahnrad eingreift, um die Werkstückaufnahme zu drehen. Bei dem Zahnrad kann es sich dabei um ein Stirnrad und bei der Innenverzahnung um ein Hohlrad handeln. Es sind jedoch auch andere Ausgestaltungen und andere Antriebe denkbar. Als Antrieb wird vorzugsweise ein Elektromotor verwendet, dessen Geschwindigkeit stufenlos regelbar sein kann, so dass die etagenförmige Werkstückaufnahme im Bereich von 1-10 Umdrehungen/Minute drehbar ist. Der Drehsinn kann umkehrbar sein, um durch ein alternieren der Drehrichtung einer Agglomeration von eventuell anfallenden Verschmutzungen vorzubeugen.

Des Weiteren können vorteilhafterweise ein oder mehrere Reaktionsgasgeneratoren im Bereich des Reaktorbodens in die Einlassleitung integriert und in der Reaktorkammer angeordnet sein. Bei einem derartigen Reaktionsgasgenerator kann es sich beispielsweise um eine Verdampfereinheit handeln, in der das zunächst flüssige Ausgangsprodukt bzw. Reaktionsprodukt verdampft wird. Alternativ ist rein beispielhaft ein Metallchloridgenerator zu nennen, bei dem beispielsweise HCl oder Cl₂ (oder Metallhalogenid MXₙ) durch ein Metall strömt, so dass sich ein Metallchlorid bildet, das schließlich über die Einlassleitung in die Reaktorkammer eingebracht wird. Die Integration dieser Verdampfereinheiten oder Metallchloridgeneratoren bzw. allgemein der Reaktionsgasgeneratoren, in die Reaktorkammer, führt zu dem Vorteil, dass keine zusätzlichen Dichtungsproblematiken entstehen. Ferner kann es vorteilhaft sein, dass diese Reaktionsgasgeneratoren separat beheizt und regelbar sind (Reaktortemperaturentkoppelung).

Des Weiteren kann es bevorzugt sein, die etagenförmige Werkstücknahme mit oder getrennt von der zentralen Auslassleitung aus dem Reaktor entnehmen zu können, so dass nach einem abgeschlossenen Prozess die Werkstückaufnahme einfach durch eine neue mit neu bestückten Werkstücken ersetzt wird und dadurch die Stillstandzeit des CVD-Reaktors niedrig gehalten werden. Hierbei kann die Auslassleitung beispielsweise über eine lösbare Kopplung dicht an- und abgekoppelt werden und ggf. eine Abdichtung zwischen Werkstückaufnahme und Reaktorboden über eine Labyrinthdichtung, d. h. eine berührungslose Dichtung, erfolgen.

Darüber hinaus kann es von Vorteil sein auch die Temperatur in der Ein- und/oder Auslassleitung zu bestimmen, so dass jeweils ein Sensor in diesen Leitungen integriert sein kann. Diese zusätzlichen Temperaturmessungen führen zu einer weiter verbesserten Prozesskontrolle.

Ferner kann in der Einlassleitung 34 ein Modul zum Spalten und/oder Zersetzen und/oder Aktivieren von Gasen (wie z. B. Kohlenwasserstoffe, Stickstoffwasserstoffverbindungen und Metallorganische-Verbindungen) für die Reaktionen in der Reaktorkammer 10 integriert werden.

Weitere Vorteile und Merkmale der vorliegenden Erfindung werden aus der folgenden Beschreibung bevorzugter Ausführungsformen ersichtlich.

### KURZE BESCHREIBUNG DER ZEICHNUNGEN

Die Beschreibung der bevorzugten Ausführungsformen erfolgt unter Bezugnahme auf die begleitenden Zeichnungen, in denen:
Fig. 1 eine erste Ausführungsform eines erfindungsgemäßen CVD-Reaktors in einer schematischen Darstellung ist;
Fig. 2 eine zweite Ausführungsform eines erfindungsgemäßen CVD-Reaktors in einer schematischen Darstellung ist;
Fig. 3 ein CVD-Reaktor ist, der den Ausgangspunkt für die vorliegende Erfindung bildet, in einer schematischen Darstellung ist.

### BESCHREIBUNG DER BEVORZUGTEN AUSFÜHRUNGSFORMEN

Gleiche oder ähnliche Elemente in den verschiedenen Zeichnungen sind der Einfachheit halber mit den gleichen Bezugsziffern versehen.

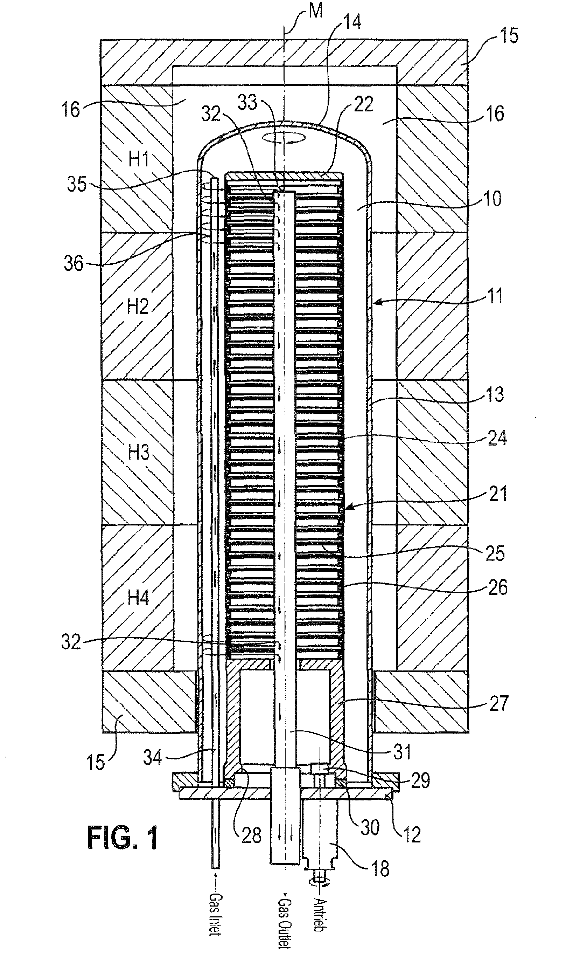

Der CVD-Reaktor der ersten Ausführungsform und wie er in Fig. 1 dargestellt ist, umfasst eine zylinderförmige und vertikal stehende Reaktorkammer 10. Diese Reaktorkammer 10 wird durch den Reaktorboden 12 und die Reaktorwandung 11 begrenzt, wobei sich die Reaktorwandung 11 aus einem hohlzylindrischen Abschnitt 13 und einer Kuppel 14 zusammensetzt.

Eine etagenförmige Werkstückaufnahme 21 ist zentral in der Reaktorkammer 10 aufgenommen (die Mittelachse M der Reaktorkammer und der Werkstückaufnahme sind deckungsgleich) und erstreckt sich über im Wesentlichen die gesamte Höhe zumindest des hohlzylindrischen Abschnitts 13 der Reaktorwandung 11. Bei einer Reaktorausführung mit Reaktionsgeneratoren in der Reaktorkammer 10, können die Werkstückaufnahme und das später beschriebene Auslassrohr 31 auch exzentrisch aufgenommen sein. Die etagenförmige Werkstückaufnahme setzt sich aus mehreren parallel und horizontal angeordneten tablettförmigen Aufnahmen 25 zusammen, auf denen zu beschichtende Werkstücke bzw. Substrate platzierbar sind. Jede der Aufnahmen 25 definiert eine Etage. Zwischen den einzelnen Aufnahmen 25 sind die Aufnahmen 25 verbindende umlaufende Wände 24 angeordnet. Diese umlaufenden Wände, die, wie es nachfolgend beschrieben ist, mit Einströmöffnungen 26 versehen sind, können auch durch einzelne die Aufnahmen 25 verbindende Stege ersetzt werden, insofern die jeweiligen Etagen bzw. die zwischen zwei benachbarten Aufnahmen 25 gebildeten Räume radial mit der Reaktorkammer in Fluidverbindung stehen. Am Ende der obersten Etage ist eine Abschlussplatte 22 vorgesehen, die den letzten Raum definiert, in dem ein Werkstück platzierbar ist, nämlich den Raum zwischen der obersten Aufnahme 25 und der Abschlussplatte 22. An die unterste Etage schließt sich ein Ständer 27 an, der im Bereich des Reaktorbodens 12 ein Hohlrad 28 mit einer Innenverzahnung aufweist. In diese Innenverzahnung des Hohlrads 28 greift die Verzahnung eines Stirnrads 29, das durch den Antrieb 18 angetrieben wird. Der Ständer 27 ist beispielsweise über Keramikgleitlager 30 oder über Rollen oder Kugellager drehbar auf dem Reaktorboden 12 gelagert. Eine weitere Lagerung kann im Bereich des später beschriebenen Auslassrohrs 31 erfolgen, ist jedoch in der Fig. 1 nicht dargestellt. Durch eine Rotation des Stirnrads 29 und den Eingriff des Stirnrads 29 in die Innenverzahnung des Hohlrads 28 ist die etagenförmige Werkstückaufnahme 21 in der Reaktorkammer 10 um die Mittelachse M des Hohlrads 28 drehbar. Die Umdrehungszahl ist dabei insbesondere von der Anzahl der Einströmöffnungen 26 in den Außenwandungen 24 der Etagen abhängig und liegt vorzugsweise in einem Bereich zwischen 1 und 10 Umdrehungen/Minute und beispielsweise zwei Löchern je Etage bei 4 Umdrehungen/Minute. Bevorzugterweise ist der Antrieb 18 stufenlos regelbar, so dass die Drehgeschwindigkeit der etagenförmigen Werkstückaufnahme beliebig anpassbar ist und auch für unterschiedliche Ausgestaltungen der gleiche Antrieb zum Einsatz kommen kann.

Die Reaktorwandung 11 des dargestellten CVD-Reaktors ist durch eine Heizung umgeben, die sich aus den Heizelementen 1-4 (Es müssen nicht zwingend 4 Heizelemente vorhanden sein. Es können weniger (1) oder mehr (>4) vorhanden sein.) zusammensetzt und einen die Reaktorwandung 11 umgebenden Raum 16 bildet. Die einzelnen Heizelemente sind separat regelbar, wobei die Leistung von der Heizung 1 zur Heizung 4 allmählich zunimmt. Durch die separate Regelung ist eine optimale Temperaturverteilung in der Reaktorkammer 10 und damit eine optimale Vorheizung der Reaktionsgase einstellbar.

Wie es aus Fig. 1 ersichtlich ist, wird zwischen dem Außenumfang der etagenförmigen Werkstückaufnahme 21 und der Reaktorwandung 11 ein schmaler Zwischenraum gebildet. In diesem Zwischenraum ist ein Gaseinlassrohr 34 vorgesehen. Das Einlassrohr 34 tritt in einem relativ zur Mittelachse M radial außen liegenden Bereich des Reaktorbodens 12 durch den Reaktorboden 12 in die Reaktorkammer 10. Das Einlassrohr 34 ist in seiner Länge bzw. Höhe derart gestaltet, dass es sich bis zur obersten Etage der Werkstückaufnahme 21 und ein geringes Stück über diese hinaus erstreckt. Im Wesentlichen schließt das obere Ende 35 des Einlassrohrs 34 mit der unteren Fläche der Abschlussplatte 22 ab. Entlang der Länge des Einlassrohrs 34 ist jeder Etage zugeordnet eine Ausströmöffnung 36 vorgesehen. Diese Ausströmöffnungen 36 sind, wie es den Pfeilen in Fig. 1 zu entnehmen ist, die die Strömung des Reaktionsgases darstellen, auf die Reaktorwandung 11 gerichtet, so dass das ausströmende Reaktionsgas auf die Reaktorwandung trifft. Durch die Elemente 1-4 wird die Reaktorwandung 11 aufgeheizt und erwärmt, so dass sie einerseits Wärme in die Reaktorkammer 10 abstrahlt und andererseits selbst heiß ist. Das auf die Reaktorwandung 11 auftreffende Reaktionsgas, das aus den Öffnungen 36 ausströmt, wird dadurch auf die gewünschte Reaktionstemperatur vorgewärmt. Das Einlassrohr 34 ist feststehend, so dass sich am Durchtritt durch den Reaktorboden 12 keine Dichtungsproblematiken ergeben und eine einfache Dichtung möglich ist. Der Querschnitt des Einlassrohrs 34 ist derart bemessen, dass die Geschwindigkeit des einströmenden Reaktionsgases derart ist, dass eine vorzeitige Reaktion und ein Abscheiden in dem Einlassrohr 34 bzw. dessen Innenoberfläche verhindert wird. Gleichzeitig ist die Geschwindigkeit jedoch derart gewählt, dass eine ausreichende Vorheizung über die Heizelemente 1-4, die die Reaktorwandung 11 aufheizen, erfolgt. Es ist auch denkbar, mehrere (beispielsweise zwei oder drei) unterschiedliche Reaktionsgase (Ausgangsgase) über eine entsprechende Zahl getrennter Einlassleitungen 34, die parallel zueinander verlaufen sollten, in die Reaktorkammer 10 einzubringen. Dies ist insbesondere bei solchen Gasen von Vorteil, die bei Temperaturen oberhalb von 200° zum Reaktionsgas zu mischen sind, wobei die Mischung jedoch erst unmittelbar vor den zu beschichtenden Werkstücken stattfinden soll. Dabei ist es von Vorteil, wenn die Ausströmöffnungen 36 der Einlassrohre 34 einander zugewandt bzw. auf die gleiche Stelle der Reaktorwandung 11 gerichtet sind.

Zentral in der Reaktorkammer 10 ist ferner ein Auslassrohr 31 angeordnet (die Mittelachse M des Auslassrohrs ist deckungsgleich mit der Mittelachse M der Reaktorkammer), das bei der vorliegenden Ausführungsform ebenfalls feststehend ist, so dass es einfach ist die Durchtrittsstelle durch den Reaktorboden 12 abzudichten. Zu diesem Zweck ist in diesem Schnittstellenbereich eine entsprechende Dichtung (nicht dargestellt) vorgesehen. Das Auslassrohr 31 erstreckt sich vom Reaktorboden 12 mit seiner Mittelachse in Deckung mit der Mittelachse der etagenförmigen Werkstückaufnahme 21 nach oben bis in die oberste Etage hinein bzw. in den Raum zwischen der obersten Aufnahme 25 und der Abschlussplatte 22. Am oberen Ende 33 ist das Einlassrohr 31 offen. Darüber hinaus sind in jeder Etage wenigstens eine bevorzugterweise jedoch mehrere Öffnungen 32 (bevorzugterweise wenigstens zwei) in dem Einlassrohr 31 vorgesehen. Durch diese Einströmöffnungen 32 kann verbrauchtes Reaktionsgas (das nicht-umgesetzte Ausgangsgase und Nebenprodukte der Reaktionen, die der Gasphasenabscheidung zugrunde liegen, enthält) in das zentrale Auslassrohr 31 einströmen. Aus der obersten Etage strömt das verbrauchte Reaktionsgas in die obere Öffnung 33 in das Auslassrohr 31. Über das Auslassrohr 31 wird das verbrauchte Reaktionsgas aus der Reaktorkammer 10 ausgeströmt.

Im Folgenden wird der Betrieb der in Fig. 1 dargestellten Ausführungsform erläutert. Die Strömungsrichtung des Reaktionsgases ist dabei durch die Pfeile in der Figur dargestellt.

Das einströmende Reaktionsgas bzw. die einströmenden Reaktionsgase werden in das Einlassrohr 34 eingeströmt und Strömen entlang des Einlassrohrs 34. Die durch die Heizelemente 1-4 erwärmte Reaktorwandung 11, insbesondere im hohlzylindrischen Abschnitt 13, führt zu einer Erwärmung des Einlassrohrs 34, so dass bereits eine Vorwärmung des Gases bei der Strömung durch das Einlassrohr 34 stattfindet. Darüber hinaus strömt das Reaktionsgas aus den Ausströmöffnungen 36 aus dem Einlassrohr 34 auf und trifft, wie bereits erwähnt, auf die Reaktorwandung 11, wodurch eine weitere Vorheizung auf die notwendige Reaktionstemperatur erfolgt. Diesbezüglich ist zu erwähnen, dass bei einem erfindungsgemäßen CVD-Reaktor das Reaktionsgas für die chemische Abscheidung vorzugsweise eine Temperatur von über 800°C erreicht. Dabei sind auch die später beschriebenen Beispiele zu berücksichtigen.

Nach dem Auftreffen auf die Reaktorwandung 11 wird das Reaktionsgas umgeleitet ("prallt" zurück) und strömt radial von der Innenfläche der Reaktorwandung 11 in Richtung der Mittelachse M. Dabei strömt das Reaktionsgas durch die Öffnungen 26 der Außenwandung 24 der Werkstückaufnahme 21, die zwischen zwei benachbarten Aufnahmen 25 angeordnet sind und in den Raum, der die jeweiligen Etagen bildet und zwischen zwei benachbarten Aufnahmen 25 gebildet ist, münden. D. h. das Reaktionsgas strömt in den Raum, auf dessen Boden (untere Aufnahme 25) ein zu beschichtendes Werkstück liegt.

Durch die Gasphasenabscheidung werden die gasförmigen Stoffe aus dem Reaktionsgas auf den Oberflächen des Werkstücks, bei dem es sich beispielsweise um Schneidplättchen, Sägeblätter etc. handeln kann, abgeschieden und bilden die gewünschte Schicht. Im Anschluss strömt das verbrauchte Reaktionsgas durch die Einströmöffnungen 32 des Auslassrohrs 31 sowie die Stirnseitenöffnung 33 des Auslassrohrs 31 in das Auslassrohr 31 aus der Reaktorkammer 10. Während dieses gesamten kontinuierlich Ein- und Ausströmvorgangs wird die etagenförmige Werkstückaufnahme 21 durch den Antrieb 18 des Zahnrads 29 um die Mittelachse M des Hohlrads 28 gedreht. Bei der bevorzugten Ausführungsform sind im Umfang der Wandung 24 der Werkstückaufnahme zwei Löcher vorgesehen und die Werkstückaufnahme 21 wird mit 4 Umdrehungen/Minute gedreht.

Da die Verweildauer des Reaktionsgases im unteren Bereich des Einlassrohrs 34 geringer ist, d. h. die Zeit, um auf die Reaktionstemperatur aufgeheizt zu werden, geringer ist als für ein Gas, das aus der obersten Ausströmöffnung 36 ausströmt und zur Begasung eines Werkstücks in der oberen Etage dient, ist die Leistung der Heizung 4 größer als die Leistung der Heizung 1, um den entsprechenden Wärmebedarf liefern zu können. Durch die separate Regelung der Heizelemente wird eine optimale Erwärmung der Reaktionsgase möglich. Ferner können Anpassungen vorgenommen werden, um eine möglichst geringe Abscheidung des Reaktionsgases auf nicht gewünschten Oberflächen zu vermeiden. Letzteres wird ferner auch durch die Anpassung der Geschwindigkeit des Reaktionsgases im Einlassrohr 34 gesteuert. Durch diese erfindungsgemäße Ausgestaltung wird bei gleich bleibender Homogenität und gleich bleibenden Schichteigenschaften die Möglichkeit geschaffen größere Gasmengen bei gleicher Zeit einzuströmen und damit den Beschichtungsvorgang zu beschleunigen. Dadurch werden die Beschichtungskosten merklich reduziert. Darüber hinaus kommt das Reaktionsgas bei der dargestellten Ausführungsform nur in ausgewählten Bereichen und auch dort nur kurz mit der Reaktorwandung 11 in Kontakt. Ansonsten ist der Weg zwischen den Ausströmöffnungen 36 und den Werkstücken kurz gehalten, so dass Abscheidungen auf ungewünschten Oberflächen, d. h. nicht auf den zu beschichtenden Werkstücken, insbesondere an der Reaktorwandung 11, reduziert werden. Eine zusätzliche Abscheidung an der Innenwand des Einlassrohrs 34 kann durch die Einstellung einer "hohen" Geschwindigkeit des Reaktionsgases bei der Durchströmung des Einlassrohrs 34 gesteuert werden. Die Strömungsgeschwindigkeit des Reaktionsgases bzw. der mehreren Ausgangsgase ist erfindungemäß generell bevorzugt im laminaren Bereich. Die Verweilzeit des Reaktionsgases im Reaktor ist üblicherweise im Sekundenbereich. Die Rotation der Werkstückaufnahme 21 führt darüber hinaus zu einer weitgehend homogenen und die Schichteigenschaften beibehaltenden Beschichtung im Vergleich zu der Ausführungsform in Fig. 3.

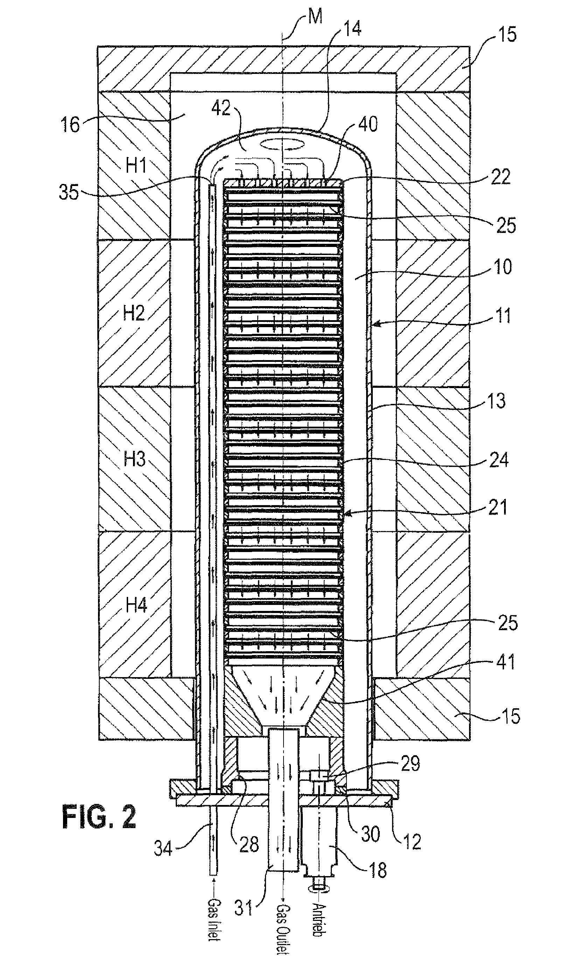

Eine zweite Ausführungsform der vorliegenden Erfindung ist in Fig. 2 dargestellt. Dabei wird auf die erneute Beschreibung von gleichen Elementen verzichtet, um Wiederholungen zu vermeiden. Darüber hinaus sei bereits ein dieser Stelle angemerkt, dass die Ausführungsformen aus den Fig. 1 und 2 auch kombiniert werden können. D. h. das Einlassrohr 34 der Ausführungsform in Fig. 1 kann zusätzlich an seinem oberen Ende 35 offen sein und die Abschlussplatte 22 kann Öffnungen 40 aufweisen. Andererseits können in der Ausführungsform in Fig. 2 auch zusätzliche Ausströmöffnungen 36 in dem dann wie in Fig. 1 ausgestalteten Einlassrohr und Einströmöffnungen 26 in der Außenwandung 24 der Werkstückaufnahme 21 vorgesehen sein.

Bei der in Fig. 2 dargestellten Ausführungsform weist das Einlassrohr bei gleicher Ausgestaltung, wie in Fig. 1, jedoch nur ein offenes Ende 35 auf. Die Ausströmöffnungen 36 sind nicht vorgesehen.

Darüber hinaus erstreckt sich das Auslassrohr 31 durch den Reaktorboden 12 um eine gewissen Strecke nach oben in Richtung der Werkstückaufnahme 21 und mündet in einem trichterförmigen Raum 41, der sich an die unterste Etage der Werkstückaufnahme 21 anschließt, d. h. der unterhalb der untersten Aufnahme 25 angeordnet ist. Die einzelnen Aufnahmen 25 sind fluiddurchlässig, z. B. mit mehreren Öffnungen oder gitterartig ausgestaltet. Diese Ausgestaltung der Aufnahmen 25 ist selbstverständlich auch auf die Ausführungsform in Fig. 1 anwendbar. Ferner sind in der Abschlussplatte 22 mehrere Öffnungen 40 vorgesehen und zwischen der Oberseite der Abschlussplatte 22 und der Unterseite der Kuppel 14 ist ein Mischraum 42 gebildet. Durch die Rotation der Werkstückaufnahme 21 wird eine Bewegung des Reaktionsgases im Mischraum 42 unterstützt bzw. induziert.

Im Folgenden wird der Betrieb des CVD-Reaktors aus Fig. 2 erläutert. Dabei wird Reaktionsgas oder bei einer getrennten Einleitung mehrere Reaktionsgase in das Einlassrohr bzw. die Einlassrohre 34 eingeströmt. Dort strömen die Gase bis zur Öffnung 35 in dem Einlassrohr 34. Die Wandung des Einlassrohrs 34 wird durch die von der Reaktorwandung 11 abgestrahlte Wärme erwärmt, so dass auch das Reaktionsgas während der Strömung erwärmt wird. Die Heizung der Reaktorwand 11 erfolgt, wie bereits erwähnt, über die Heizelemente 1-4. An dem dem Reaktorboden 12 abgewandten offenen Ende 35 strömt das Reaktionsgas aus dem Einlassrohr 34 in den Mischraum 42. Bei mehreren getrennt eingeleiteten Gasen werden diese im Mischraum 42 gemischt. Andernfalls kann in diesem Bereich eine zusätzliche letzte Erwärmung des Reaktionsgases auf die gewünschte Reaktionstemperatur erfolgen, da auch dieser Bereich durch das Heizelement 1 zusätzlich erwärmt wird. Aus dem Mischraum 42 tritt durch die Öffnungen das Reaktionsgas 40 aus und strömt von der obersten Etage durch die einzelnen Aufnahmen 25 der Werkstückaufnahme 21, auf denen die einzelnen Werkstücke liegen nach unten in Richtung des trichterförmigen Raums 41. Dabei werden die 3-dimensionalen Werkstücke wie gewünscht beschichtet. Schließlich strömt das verbrauchte Reaktionsgas über den trichterförmigen Raum 41, der in das Auslassrohr 31 mündet, über das Auslassrohr 31 aus der Reaktorkammer 10 aus. Während dieses Vorgangs wird die Werkstückaufnahme 21 kontinuierlich oder taktweise durch den Antrieb 18 gedreht.

Wie bereits zuvor erwähnt wurde, können die Ausführungsformen in den Fig. 1 und 2 kombiniert werden, wobei verschiedene Kombinationsmöglichkeiten, wie sie erwähnt wurden, denkbar sind.

Darüber hinaus versteht es sich auch, dass die Ausgestaltung des Einlassrohrs 34, wie es beschrieben wurde, auch ohne Rotation die Werkstückaufnahme 21 zu dem besagten Vorteilen, insbesondere hinsichtlich einer geringeren Ablagerung an ungewünschten Oberflächen führt. Mit anderen Worten handelt es sich bei der Ausgestaltung des Einlassrohrs entlang der beheizbaren Reaktorwandung 11 um einen separaten Aspekt der Erfindung, der auch unabhängig von der Rotationsmöglichkeit der etagenförmigen Werkstückaufnahme umgesetzt werden kann. Diesbezüglich ist es nur wesentlich, dass das Einlassrohr 34 eine solche Länge aufweist, dass eine ausreichende Vorwärmung des Reaktionsgases vor dem Ausströmen der Werkstücke möglich ist und darüber hinaus ein möglichst kurzer Weg zu den Werkstücken vorhanden ist.

Der vorliegende CVD-Reaktor ermöglicht eine Reaktionstemperatur bzw. Abscheidungstemperatur von über 720°C. Er kann daher auch als Mittel und Hochtemperatur-CVD-Reaktor bezeichnet werden. Der erfindungsgemäße CVD-Reaktor kann diesbezüglich sowohl in einer Vakuumatmosphäre als auch in einer Überdruckatmosphäre oder ggf. auch bei Atmosphärendruck betrieben werden. Darüber hinaus sind die Komponenten des Reaktors derart gewählt, dass sie den hohen Temperaturen auch bei Anwesenheit korrosiver Verbindungen (beispielsweise HCl), standhalten, was insbesondere bei der Auswahl der Materialien und insbesondere der Auswahl der Materialien für die Dichtungen und Lager wesentlich ist.

Der erfindungsgemäße CVD-Reaktor ist beispielsweise für das Aufbringen verschiedenster CVD-Beschichtungen, insbesondere Hartstoffbeschichtungen auf Werkstücken, wie beispielsweise Schneiden (insbesondere Schneidblättchen) und Sägeblättern geeignet. Geeignete Hartstoffe sind beispielsweise Carbide, Nitride, Carbonitride der Übergangsmetalle Titan, Tantal, Wolfram, Molybdän und Chrom, Boride der Eisenmetalle (Ni und Fe) und Oxide des Aluminiums, Zirkoniums, Hafnium und Siliziums. Insbesondere kann der erfindungsgemäße CVD-Reaktor für die Abscheidung von TiC, TiN, Ti(C,N), Cr7C3, Ni- und Fe-Boride und Al2O3, einzeln oder kombiniert in Schichten mit stufenweisen oder kontinuierlichen Übergängen, verwendet werden. Es versteht sich, dass diese Aufzählung nicht abschließend, sondern nur beispielhaft ist.

Je nach der gewünschten Beschichtung wird der Fachmann ein geeignetes Reaktionsgas auswählen und dies über eine Einlassleitung 34 oder in Form mehrerer Reaktionsgase (Ausgangsgase) über mehrere Einlassleitungen 34 in die Reaktionskammer 10 einströmen lassen. Zur Erzeugung einer Ti(C,N)-Beschichtung auf den Werkstücken kann beispielsweise ein Reaktionsgas verwendet werden, das TiCl4, Acetonitril und Wasserstoff enthält.

Weitere beispielhafte Parameterbereiche und Anwendungsfälle sind im Folgenden nicht abschließend genannt:

### Beispiele:

| Parameter Einheit | Bereich aus der Praxis | | Theoretisch denkbarer Bereich | |
|---|---|---|---|---|
| Temperatur °C | 500 | 1100 | 200 | 1600 |
| Druck mbar | 40 | P atm | 1 | P atm |
| Verweilzeiten sec | 0.01 | 100 | 10⁻⁵ | 10⁴ |

### Träger- und reaktive Gase:

Wasserstoff, Stickstoff, Kohlenwasserstoffe, (gesättigt ungesättigt, Aromate) Amine, Ammoniak, Hydrazine Kohlendioxid, Kohlenmonoxid, Stickstoffmonoxid, Silane, Borane, Halogenide. BCl3, SiCl4 SiCl3CH3, WF6.

### Bei Raumtemperatur flüssige Ausgangsstoffe:

TiCl4, BBr3, CH3CN, CH3OH, Metallorganische Verbindungen z.B. Trimethylaluminium, Platin-Actonylacetonat, VCl4.

### Feste Verbindungen (niedriger Dampfdruck):

CrCl2, MoCl5 TiJ4, AlCl3, HfCl4, NbCl5.

### Schichten:

Karbide, Nitride, Oxide, Boride, Silizide, Phosphide, der Übergangsmetalle, IVB-VIIB, sowie kovalente Verbindungen von Si, N, Al, C .... als Monoschichten, Mehrlagenschichten, Gradienten Mischungen, Einlagerungen, Multylaers.

### Grundmaterialien:

reine Metalle, Legierungen, Stähle, Hartmetalle, Superlegierungen, Keramik, Grafite, etc.

## Patentansprüche

1. CVD-Reaktor zur Abscheidung von Schichten aus einem Reaktionsgas auf Werkstücken, umfassend:
- eine längliche, vertikal verlaufende Reaktorkammer (10), die durch eine zumindest teilweise beiheizte Reaktorwandung (11) und einen Reaktorboden (12) begrenzt ist,
- eine Einlassleitung (34) zum Einströmen des Reaktionsgases in die Reaktorkammer (10), die im Bereich des Reaktorbodens (12) in die Reaktorkammer (10) tritt,
- eine Auslassleitung (31) zum Ausströmen des verbrauchten Reaktionsgases aus der Reaktionskammer (10), die im Bereich des Reaktorbodens aus der Reaktorkammer (10) tritt,
- eine etagenförmige Werkstückaufnahme (21), die in der Reaktorkammer (10) angeordnet ist und um ihre Mittelachse drehbar ist, wobei die Mittelachse der Werkstückaufnahme und die Mittelachse der Auslassleitung deckungsgleich sind, **dadurch gekennzeichnet, dass** die Auslassleitung feststehend ausgestaltet ist und die Einlassleitung zwischen der Werkstückaufnahme und der Reaktorwandung angeordnet ist.

2. CVD-Reaktor nach Anspruch 1, bei dem die Einlassleitung (34) ein Rohr ist, dass sich parallel zum beheizbaren Teil der Reaktorwandung (10) erstreckt.

3. CVD-Reaktor nach Anspruch 2, bei dem die Länge der Einlassleitung (34) derart bemessen ist, dass sie sich im Wesentlichen bis zur obersten Etage der Werkstückaufnahme (21) erstreckt.

4. CVD-Reaktor nach Anspruch 3, bei dem pro Etage der Werkstückaufnahme entsprechend der jeweiligen Etage wenigstes eine Öffnung (36) in der Einlassleitung vorgesehen ist und die Etagen radial zugänglich (26) sind, so dass Reaktionsgas aus den Öffnungen (36) der Einlassleitung radial entlang der Etagen zur zentralen Auslassleitung (31) strömbar ist.

5. CVD-Reaktor nach einem der vorstehenden Ansprüche, bei dem die Auslassleitung (31) ein Rohr ist, dass sich zentral vom Reaktorboden (12) zur obersten Etage erstreckt und pro Etage auf Höhe der jeweiligen Etage wenigstes eine Öffnung (36) zum Einströmen des verbrauchten Reaktionsgases in die Auslassleitung (31) aufweist.

6. CVD-Reaktor nach einem der vorstehenden Ansprüche 2 bis 5, bei dem die Einlassleitung (34) an ihrem dem Reaktorboden (12) abgewandten Ende (35) offen ist und die Werkstückaufnahme (21) an ihrem dem Reaktorboden (12) abgewandten Ende eine mit Öffnungen (40) versehene Abschlussplatte (22) aufweist, so dass Reaktionsgas aus der Öffnung (35) der Einlassleitung (34) durch die Öffnungen (40) in der Abschlussplatte (22) in Richtung des Reaktorbodens (12) und über die zentrale Auslassleitung (31) aus der Reaktorkammer (10) strömbar ist.

7. CVD-Reaktor nach einem der vorstehenden Ansprüche, bei dem mehrere Einlassleitungen (34) vorgesehen sind über die mehrere unterschiedliche Reaktionsgase getrennt in die Reaktorkammer (10) strömbar sind, um sich in der Reaktorkammer (10) zu dem Reaktionsgas zu mischen.

8. CVD-Reaktor nach Anspruch 7, bei dem die Einlassleitung mehrere Kanäle aus Wärme isolierendem Material umfasst.

9. CVD-Reaktor nach Anspruch 6, 7 oder 8, bei dem im Bereich oberhalb der Abschlussplatte (22) ein Mischraum (42) in der Reaktorkammer (10) definiert ist, in den das Reaktionsgas einströmbar ist.

10. CVD-Reaktor nach Anspruch 7, bei dem in den Einlassleitungen (34) ausgebildete Öffnungen (36) so ausgerichtet sind, dass die ausströmenden Reaktionsgase aufeinander treffen.

11. CVD-Reaktor nach einem der vorstehenden Ansprüche, bei dem die Werkstückaufnahme (21) im Bereich des Reaktorbodens (12) eine Innenverzahnung (28) aufweist in die ein angetriebenes Zahnrad (29) eingreift, um die Werkstückaufnahme (21) zu drehen.

12. CVD-Reaktor nach einem der vorstehenden Ansprüche, bei dem ein oder mehrere Reaktionsgasgeneratoren im Bereich des Reaktorbodens in die Einlassleitung integriert und in der Reaktorkammer angeordnet sind.

13. CVD-Reaktor nach einem der vorstehenden Ansprüche, bei dem in der Einlassleitung (34) ein Modul zum Spalten, Zersetzen und/oder Aktivieren von Gasen in der Reaktorkammer (10) integriert ist.

14. CVD-Reaktor nach einem der vorstehenden Ansprüche, bei dem die Auslassleitung (31) und/oder die Werkstückaufnahme (21) zentral angeordnet sind.

15. CVD-Reaktor nach einem der vorstehenden Ansprüche, bei dem die Werkstückaufnahme nur um ihre Mittelachse drehbar ist.

## Claims

1. CVD reactor for separating layers from a reaction gas on workpieces, comprising:
- an elongate, vertically extending reactor chamber (10) which is delimited by an at least partially heated reactor wall (11) and a reactor bottom (12),
- an inlet pipe (34) for inflow of the reaction gas into the reactor chamber (10), which passes into the reactor chamber (10) in the region of the reactor bottom (12),
- an outlet pipe (31) for outflow of the spent reaction gas from the reaction chamber (10), which passes out of the reactor chamber (10) in the region of the reactor bottom,
- a tiered workpiece holder (21) which is arranged in the reactor chamber (10) and rotatable about its centre axis, wherein the centre axis of the workpiece holder and the centre axis of the outlet pipe coincide, **characterised in that** the outlet pipe is stationary and the inlet pipe is arranged between the workpiece holder and the reactor wall.

2. CVD reactor according to claim 1, in which the inlet pipe (34) is a pipe which extends parallel to the heatable portion of the reactor wall (10).

3. CVD reactor according to claim 2, in which the length of the inlet pipe (34) is such that it extends substantially as far as the uppermost tier of the workpiece holder (21).

4. CVD reactor according to claim 3, in which, for every tier of the workpiece holder, corresponding to the respective tier, at least one opening (36) is provided in the inlet pipe, and the tiers are radially accessible (26) so that reaction gas can flow out of the openings (36) in the inlet pipe radially along the tiers to the central outlet pipe (31).

5. CVD reactor according to any of the preceding claims, in which the outlet pipe (31) is a pipe which extends centrally from the reactor bottom (12) to the uppermost tier, and for every tier at the level of the respective tier has at least one opening (36) for inflow of the waste reaction gas into the outlet pipe (31).

6. CVD reactor according to any of the preceding claims 2 to 5, in which the inlet pipe (34) is open at its end (35) remote from the reactor bottom (12), and the workpiece holder (21) at its end remote from the reactor bottom (12) has an end plate (22) provided with openings (40), so that reaction gas can flow out of the opening (35) in the inlet pipe (34) through the openings (40) in the end plate (22) towards the reactor bottom (12) and via the central outlet pipe (31) out of the reactor chamber (10).

7. CVD reactor according to any of the preceding claims, in which several inlet pipes (34) are provided, via which several different reaction gases can flow separately into the reactor chamber (10) in order to mix in the reactor chamber (10) to form the reaction gas.

8. CVD reactor according to claim 7, in which the inlet pipe comprises several channels made of heat-insulating material.

9. CVD reactor according to claim 6, 7 or 8, in which in the region above the end plate (22) a mixing chamber (42) is defined in the reactor chamber (10), into which the reaction gas can flow.

10. CVD reactor according to claim 7, in which openings (36) formed in the inlet pipes (34) are oriented in such a way that the outflowing reaction gases meet.

11. CVD reactor according to any of the preceding claims, in which the workpiece holder (21) in the region of the reactor bottom (12) has an internal tooth system (28) in which a driven gear (29) engages in order to turn the workpiece holder (21).

12. CVD reactor according to any of the preceding claims, in which one or more reaction gas generators are integrated in the inlet pipe and arranged in the reactor chamber in the region of the reactor bottom.

13. CVD reactor according to any of the preceding claims, in which a module for splitting, decomposing and/or activating gases in the reactor chamber (10) is integrated in the inlet pipe (34).

14. CVD reactor according to any of the preceding claims, in which the outlet pipe (31) and/or the workpiece holder (21) are arranged centrally.

15. CVD reactor according to any of the preceding claims, in which the workpiece holder is rotatable only about its centre axis.

## Revendications

1. Réacteur de dépôt chimique en phase vapeur, pour le dépôt sur des pièces de couches provenant d'un gaz de réaction, comprenant :
- une chambre de réacteur (10) à extension verticale oblongue, délimitée par une paroi de réacteur (11) au moins partiellement chauffée et par une base de réacteur (12),
- une conduite d'entrée (34) pour l'admission du gaz de réaction dans la chambre de réacteur (10), qui pénètre dans la chambre de réacteur (10) au niveau de la base de réacteur (12),
- une conduite de sortie (31) pour l'évacuation du gaz de réaction usé hors de la chambre de réacteur (10), qui sort de la chambre de réacteur (10) au niveau de la base de réacteur,
- un logement de pièces étagé (21), disposé dans la chambre de réacteur (10) et rotatif autour de son axe central, l'axe central du logement de pièces et l'axe central de la conduite de sortie coïncidant l'un avec l'autre, **caractérisé en ce que** la conduite de sortie est prévue fixe et **en ce que** la conduite d'entrée est disposée entre le logement de pièces et la paroi de réacteur.

2. Réacteur de dépôt chimique en phase vapeur selon la revendication 1, où la conduite d'entrée (34) est un tuyau qui s'étend parallèlement à la partie susceptible d'être chauffée de la paroi de réacteur (10).

3. Réacteur de dépôt chimique en phase vapeur selon la revendication 2, où la longueur de la conduite d'entrée (34) est mesurée de manière à s'étendre sensiblement jusqu'à l'étage supérieur du logement de pièces (21).

4. Réacteur de dépôt chimique en phase vapeur selon la revendication 3, où au moins une ouverture (36) est prévue dans la conduite d'entrée par étage du logement de pièces en fonction de l'étage respectif, et où les étages sont accessibles radialement (26), si bien que le gaz de réaction peut s'écouler par les ouvertures (36) de la conduite d'entrée, radialement le long des étages vers la conduite de sortie (31) centrale.

5. Réacteur de dépôt chimique en phase vapeur selon l'une des revendications précédentes, où la conduite de sortie (31) est un tuyau qui s'étend centralement de la base de réacteur (12) à l'étage supérieur, et comporte par étage au moins une ouverture (36) au niveau de l'étage respectif pour la pénétration du gaz de réaction usé dans la conduite de sortie (31).

6. Réacteur de dépôt chimique en phase vapeur selon l'une des revendications 2 à 5, où la conduite d'entrée (34) est ouverte à son extrémité (35) distante de la base de réacteur (12) et le logement de pièces (21) comporte à son extrémité distante de base de réacteur (12) une plaque d'extrémité (22) dotée d'ouvertures (40), si bien que le gaz de réaction peut s'écouler hors de l'ouverture (35) de la conduite d'entrée (34) vers la base de réacteur (12) par les ouvertures (40) de la plaque d'extrémité (22), et hors de la chambre de réacteur (10) par la conduite de sortie centrale (31).

7. Réacteur de dépôt chimique en phase vapeur selon l'une des revendications précédentes, où plusieurs conduites d'entrée (34) sont prévues, au moyen desquelles plusieurs gaz de réaction différents peuvent être refoulés séparément vers la chambre de réacteur (10), pour se mélanger en gaz de réaction dans la chambre de réacteur (10).

8. Réacteur de dépôt chimique en phase vapeur selon la revendication 7, où la conduite d'entrée comprend plusieurs canaux en matériau thermiquement isolant.

9. Réacteur de dépôt chimique en phase vapeur selon la revendication 6, 7 ou 8, où un compartiment de mélange (42) est défini dans la chambre de réacteur (10) dans la région au-dessus de la plaque d'extrémité (22), où peut s'écouler le gaz de réaction.

10. Réacteur de dépôt chimique en phase vapeur selon la revendication 7, où les ouvertures (36) ménagées dans les conduites d'entrée (34) sont orientées de manière à faire se rencontrer les gaz de réaction évacués.

11. Réacteur de dépôt chimique en phase vapeur selon l'une des revendications précédentes, où le logement de pièces (21) présente une denture intérieure (28) au niveau de la base de réacteur (12), avec laquelle s'engrène une roue dentée (29) entraînée pour tourner le logement de pièces (21).

12. Réacteur de dépôt chimique en phase vapeur selon l'une des revendications précédentes, où un ou plusieurs générateurs de gaz de réaction sont intégrés dans la conduite d'entrée au niveau de la base de réacteur, et sont disposés dans la chambre de réacteur.

13. Réacteur de dépôt chimique en phase vapeur selon l'une des revendications précédentes, où dans la conduite d'entrée (34) un module pour la séparation, la dégradation et/ou l'activation de gaz est intégré à la chambre de réacteur (10).

14. Réacteur de dépôt chimique en phase vapeur selon l'une des revendications précédentes, où la conduite de sortie (31) et/ou le logement de pièces (21) sont disposés centralement.

15. Réacteur de dépôt chimique en phase vapeur selon l'une des revendications précédentes, où le logement de pièces n'est rotatif qu'autour de son axe central.
